# FASCICULE DE BREVET EUROPEEN

(11) **EP 1 196 987 B1**
(45) Date de publication et mention de la délivrance du brevet: **15.10.2003**
(21) Numéro de dépôt: 00949683.7
(22) Date de dépôt: 07.07.2000
(51) Int. Cl.: H03F 1/32

(54) **LINEARISEUR POUR AMPLIFICATEUR HYPERFREQUENCE**
LINEARISIERER FÜR MIKROWELLENVERSTÄRKER
LINEARIZER FOR MICROWAVE AMPLIFIER

(30) Priorité: 16.07.1999 FR 9909275
(43) Date de publication de la demande: 17.04.2002
(73) Titulaire: Thales, 75008 Paris (FR)
(72) Inventeur: PERRIN, Olivier, Thomson-CSF P.I. Départ. Brevets, 94117 Arcueil Cedex (FR); ANDRE, Frédéric, Thomson-CSF P.I. Départ. Brevets, 94117 Arcueil Cedex (FR)
(74) Mandataire: Nguyen Van Yen, Christian
(86) Numéro de dépôt international: FR0001977
(87) Numéro de publication internationale: WO01006642

(56) Documents cités:
- "POWER AMPLIFIER FOR MICROWAVE DIGITAL RADIOS WITH INHERENT PHASE COMPENSATION" IEE PROCEEDINGS H. MICROWAVES, ANTENNAS & PROPAGATION,GB,INSTITUTION OF ELECTRICAL ENGINEERS. STEVENAGE, vol. 135, no. 5, PART H, 1 octobre 1988 (1988-10-01), pages 344-346, XP000031443 ISSN: 1350-2417
- NAROZNY P ET AL: "PSEUDOMORPHIC KU-BAND GAAS HFET LINEARIZER PREAMPLIFIER FRONT END FOR SATELLITE TWT-AMPLIFIERS" IEEE GALLIUM ARSENIDE INTEGRATED CIRCUITS (GAAS IC) SYMPOSIUM,US,NEW YORK, IEEE, vol. SYMP. 17, 1995, pages 292-295, XP000630186 ISBN: 0-7803-2967-8

## Description

La présente invention concerne les amplificateurs hyperfréquence.

Ces amplificateurs peuvent être réalisés en technologie du type tube à onde progressive ou en technologie semiconducteur. Ils s'appliquent notamment aux télécommunications ou aux radars.

Un étage d'amplification pris isolément a nécessairement un gain décroissant à partir d'une certaine puissance d'entrée, généralement inférieure à la puissance de saturation à laquelle l'étage d'amplification doit fonctionner pour présenter un rendement suffisant. Il en résulte des distorsions dans le signal transmis qui créent elles-mêmes des interférences intersymboles d'autant plus gênantes que la bande passante est utilisée de manière dense, ce qui est l'objectif poursuivi, notamment dans les télécommunications. Lesdites distorsions présentent l'inconvénient supplémentaire de ne pas être stables en température.

C'est pourquoi l'on utilise des dispositifs pour linéariser un étage d'amplification hyperfréquence, qui ont pour objectif commun de corriger les non linéarités de l'étage d'amplification de manière à assurer un gain constant à l'étage d'amplification prés de la puissance de saturation et sur la totalité de la bande passante dudit étage dans une plage de températures correspondant aux conditions de fonctionnement de l'équipement.

Trois types principaux de dispositifs linéariseurs sont décrits dans l'état de l'art.

Le premier type est constitué par les dispositifs linéariseurs à boucle de rétroaction, dans lesquels les paramètres d'amplitude et de phase du signal de sortie de l'étage d'amplification sont mesurés pour en déduire les corrections à appliquer au signal d'entrée pour obtenir un signal de sortie linéaire. (Voir notamment les brevets US 4,291,277, US 5,598,127, US 5,422,598, US 5,469,114, US 5,524,285 et US 5,722,056). Compte tenu du retard introduit par la boucle de rétroaction, ces dispositifs ne sont pas utilisables pour des bandes passantes supérieures à 100 MHz.

Le deuxième type est constitué par les dispositifs linéariseurs à boucle ouverte dans lesquels diverses techniques de traitement numérique sont appliquées aux composantes d'amplitude, de phase ou d'impulsion du signal pour corriger les distorsions. (Voir notamment US 5,760,646, US 5,877,653 et US 5,886,573). Ces dispositifs supposent le recours à des techniques complexes de traitement numérique du signal et l'emploi de circuits spécifiques adaptés à la forme d'onde émise. Cette voie n'est pas praticable aujourd'hui en raison des limites de la technologie semiconducteur pour des fréquences porteuses supérieures à quelques gigahertz.

Le troisième type est constitué par les dispositifs linéariseurs à prédistorsion dans lesquels le signal d'entrée est soumis avant d'être introduit dans l'étage d'amplification à une distorsion de gain croissant avec la puissance d'entrée qui vient compenser le plus exactement possible la distorsion symétrique de l'étage d'amplification.

La présente invention appartient à ce troisième type. (De même que US 4,878,030, US 5,146,177, US 5,291,148, US 5,523,716, US 5,576,660 et US 5,736,898, ce dernier brevet de Kohi et al. constituant l'état de l'art de référence de la présente invention).

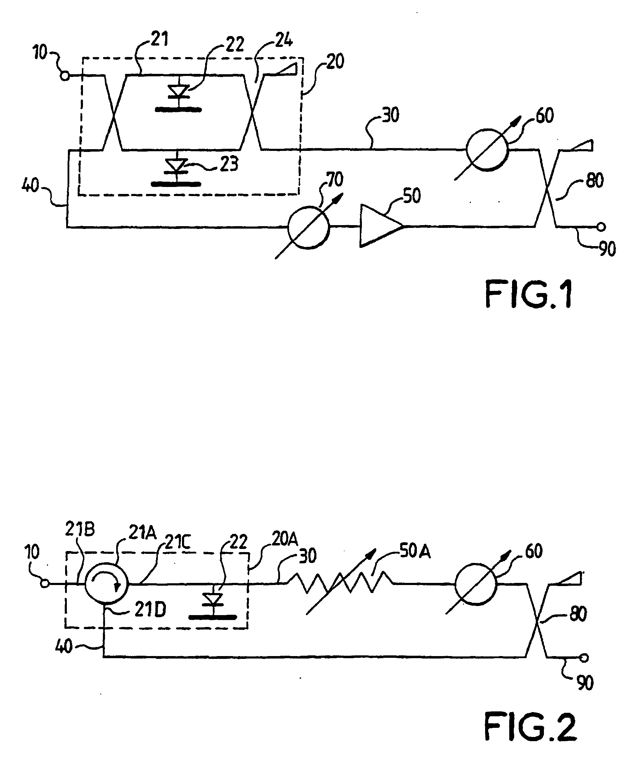

Dans Kohl et al., dont le schéma de principe est illustré dans la Figure 1 ci-dessous, le signal d'entrée (10) est soumis à un séparateur (20) constitué de deux diodes Schottky identiques (22 et 23), montées en parallèle entre deux circuits coupleurs (21 et 24), les paramètres des diodes étant choisis pour que le dispositif de séparation ne laisse passer vers une voie dite de compression (30) que les signaux de faible amplitude, les signaux de forte amplitude étant réfléchis vers une autre voie dite voie d'expansion (40) connectée à une des branches du coupleur d'entrée pour être présentés à un amplificateur (50), la voie de compression et la voie d'expansion étant recombinées pour être présentés à l'entrée de l'étage d'amplification (90) par un coupleur combineur 80). Les voies 30 et 40 sont munies de dispositifs de contrôle de phase (60 et 70).

Ce dispositif présente l'avantage théorique de réaliser un contrôle automatique de la phase du signal réfléchi. Or cet avantage théorique est difficile à obtenir en pratique en raison de la dispersion des paramètres de fabrication et de fonctionnement des diodes. De plus, lorsque le dispositif de séparation s'écarte des conditions de fonctionnement équilibrées obtenues dans le cas de deux diodes identiques, le signal réfléchi vient perturber le signal d'entrée d'un coefficient de réflexion variable avec la puissance d'entrée.

La présente invention a pour but de corriger ces défauts de l'art antérieur.

A ces fins, l'invention propose un dispositif linéariseur pour étage d'amplification hyperfréquence du type comprenant une entrée, suivie d'un séparateur opérant par réflexion sélective en fonction du niveau, qui alimente en direct une voie de compression, et par réflexion une voie d'expansion, tandis que les sorties de ces deux voies sont réunies par un coupleur combineur pour aller vers l'étage d'amplification,
**caractérisé en ce que** le séparateur comporte un circulateur, dont l'accès d'entrée est relié à l'entrée du dispositif, en ce qu'un unique montage à réflexion sélective en fonction du niveau est placé après l'accès d'entrée/sortie du circulateur, et suivi de l'une desdites voies, et en ce que l'accès de sortie du circulateur est relié à l'autre voie.

Le dispositif comporte en outre sur la voie de compression ou sur la voie d'expansion un circuit de contrôle de phase, ajusté en fonction d'une loi de compensation de phase choisie, et un circuit de contrôle d'amplitude.

Le dispositif est également caractérisé par des longueurs de lignes hyperfréquences sur les voies de compression et d'expansion sensiblement identiques.

Le dispositif peut enfin être articulé sur des composants fonctionnant en mode passif.

L'invention sera mieux comprise, et ses différentes caractéristiques et avantages ressortiront de la description qui suit d'un exemple de réalisation, et de ses figures annexées, dont:
- la figure 1, déjà décrite, montre un linéariseur à prédistorsion de l'art antérieur;
- la figure 2, montre schématiquement un exemple d'une réalisation d'un linéariseur à prédistorsion selon l'invention;
- la figure 3, montre schématiquement comment se recombinent les signaux de la voie de compression et de la voie d'expansion au sein du dispositif linéariseur selon l'invention.
- la figure 4, montre schématiquement l'évolution, en fonction de la puissance du signal d'entrée, de la puissance de sortie du dispositif linéariseur selon l'invention, de la puissance de sortie de l'étage d'amplification sans dispositif linéariseur et de la puissance de sortie de l'étage d'amplification muni du dispositif linéariseur selon l'invention; et

La figure 2 montre un exemple d'un dispositif linéariseur pour étage d'amplification hyperfréquence selon l'invention. Comme dans la figure précédente, le signal d'entrée (10) est présenté à un séparateur (20A). Ce séparateur (20A) n'est cependant constitué que de deux éléments, un circulateur (21A) et un montage à diode Schottky (22), au lieu de quatre (21, 22, 23, 24) pour le séparateur (20).

Le montage à diode Schottky est adapté en impédance aux signaux de faible amplitude. Le niveau de la puissance d'entrée auquel le montage à diode est adapté est choisi en fonction des paramètres de fonctionnement de l'étage d'amplification à linéariser. Pour ces signaux de faible puissance, le montage à diode Schottky fonctionne comme un condensateur. La technique d'adaptation, connue de l'homme de l'art, consiste à ajouter deux inductances à ce condensateur, les valeurs desdites inductances étant choisies par résolution des équations connues de l'homme du métier donnant l'impédance équivalente de ce circuit. Les inductances peuvent n'être constituées que par les inductances de câblage.

Pour les signaux d'amplitude inférieure à l'amplitude à laquelle il est adapté, le signal est transmis à la voie de compression (30).

Pour les signaux d'amplitude supérieure à l'amplitude à laquelle il est adapté, le montage à diode Schottkty fonctionne en court-circuit et le signal est réfléchi vers le circulateur (21A). Le circulateur comporte un accès d'entrée (21B), un accès d'entrée/sortie (21C) et un accès de sortie (21D). Comme il est connu de l'homme de l'art versé en hyperfréquences, le circulateur assure une excellente isolation du signal réfléchi et du signal d'entrée. Le signal est donc transmis vers la voie d'expansion (40) sans distorsion du signal d'entrée.

Un circuit d'atténuation ajustable (50A) est placé sur la voie de compression. Il peut être remplacé (ou, dans certains cas, complété) par un circuit d'amplification sur la voie d'expansion. Dans les deux cas il s'agit d'amplifier les effets de la séparation des deux voies.

Un circuit de contrôle de phase ajustable (60) sera placé soit sur la voie de compression, soit sur la voie d'expansion. Ce circuit permet d'ajuster la variation de phase en fonction des caractéristiques de l'étage d'amplification. L'ajustement pourra être effectué pour produire une avance de phase en sortie du dispositif, ce qui sera choisi lorsque l'étage d'amplification est un tube à onde progressive. Il peut être effectué pour produire un retard de phase en sortie du dispositif, ce qui sera choisi lorsque l'étage d'amplification est un dispositif semiconducteur. Si les variations de fabrication de ces deux circuits sont faibles, l'ajustement pourra être simulé pour un même type d'étage d'amplification et aucun réglage usine ne sera nécessaire.

Les voies de compression et d'expansion sont ensuite recombinées dans un coupleur classique (80) et le signal de sortie (90) est conduit vers l'étage d'amplification.

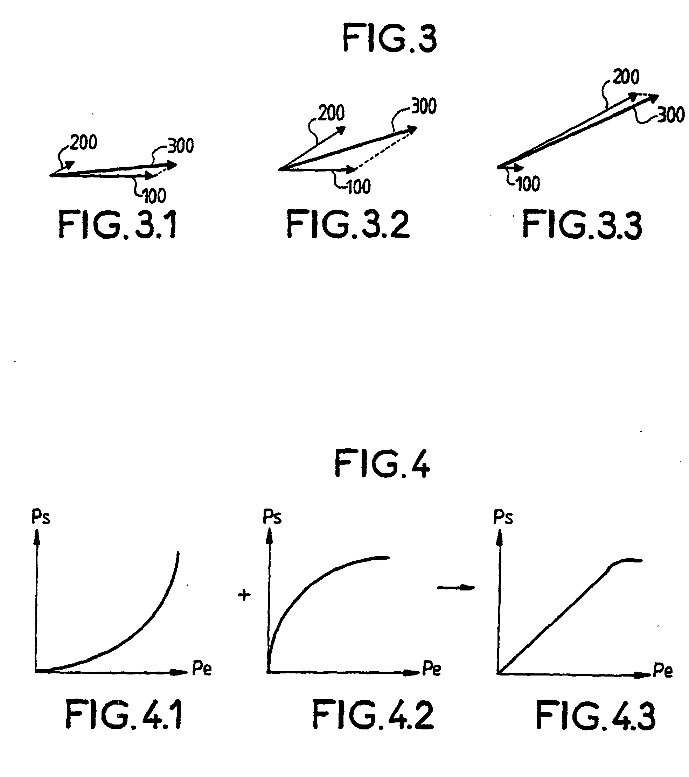

La figure 3 illustre sur des diagrammes de Fresnel, la manière dont se recombinent les vecteurs représentatifs des signaux produits sur les voies de compression et d'expansion pour des niveaux croissants du signal d'entrée. Cette illustration correspond à une avance de phase . Les figures 3.1, 3.2 et 3.3 illustrent respectivement trois cas de recornbinaison en un signal (300) des signaux de la voie de compression (100) et de la voie d'expansion (200). Le niveau du signal (200) est croissant avec le signal d'entrée. Le signal de sortie (300) croît plus que proportionnellement.

La figure 4 illustre l'effet du dispositif linéariseur sur le signal en entrée (figure 4.1) et sur le signal en sortie de l'étage d'amplification (figure 4.3), l'étage d'amplification étant supposé produire sur un signal non soumis à un dispositif linéariseur l'effet illustré par la figure 4.2. La figure 4.1 montre un gain croissant (Pₛ/ Pₑ) avec la puissance d'entrée (Pₑ), la figure 4.2 un gain décroissant et la figure 4.3 un gain constant sur une plage étendue de puissances d'entrée, correspondant aux conditions de fonctionnement de l'étage d'amplification.

Les voies de compression et d'expansion seront de longueurs hyperfréquences sensiblement identiques.

Les composants peuvent ne pas être alimentés et le dispositif fonctionnera alors en mode purement passif.

Les composants sont reportés par des techniques connues de l'homme de l'art versé dans les technologies microélectroniques. La diode Schottky est reportée soit sous forme de puce nue sur un circuit microruban sur substrat alumine couche mince ou couche épaisse en fonction de la fréquence d'utilisation, soit en boîtier par report CMS (Composant Monté en Surface) sur un circuit imprimé de plus faible coût.

A la place d'une diode Schottky, on pourrait utiliser un autre composant limiteur à effet non linéaire, comme un transistor à effet de champ.

Bien que l'invention soit particulièrement intéressante à de hautes fréquences au delà de 5 GHz, comme 10 à 20 GHz, elle peut trouver application dans d'autres bandes.

## Revendications

1. Dispositif linéariseur pour étage d'amplification hyperfréquence du type comprenant une entrée (10), suivie d'un séparateur (20A) opérant par réflexion sélective en fonction du niveau, qui alimente en direct une voie de compression (30), et par réflexion une voie d'expansion (40), tandis que les sorties de ces deux voies sont réunies par un coupleur combineur (80) pour aller vers l'étage d'amplification, **caractérisé en ce que** le séparateur comporte un circulateur (21A), dont l'accès d'entrée (21B) est relié à l'entrée du dispositif (10), **en ce qu'**un unique montage à réflexion sélective en fonction du niveau (22) est placé après l'accès d'entrée/sortie du circulateur (21C), et suivi de l'une desdites voies, et **en ce que** l'accès de sortie (21D) du circulateur est relié à l'autre voie.

2. Dispositif selon la revendication 1, **caractérisé en ce que** ledit unique montage à réflexion sélective (22) est du type limiteur.

3. Dispositif selon l'une des revendications 1 et 2, **caractérisé en ce que** ledit unique montage à réflexion sélective en fonction du niveau (22) est fondé sur une diode Schottky montée en dérivation.

4. Dispositif selon l'une des revendications 1 à 3, **caractérisé en ce que** l'une des deux voies comprend un circuit de contrôle de phase (60), ajusté en fonction d'une loi de compensation de phase choisie.

5. Dispositif selon l'une des revendications précédentes, **caractérisé en ce que** la voie de compression (30) comprend un circuit atténuateur ajustable (50A).

6. Dispositif selon l'une des revendications 1 à 5, **caractérisé en ce que** la voie d'expansion (40) comprend un circuit amplificateur à gain variable.

7. Dispositif selon l'une des revendications précédentes, **caractérisé en ce que** les voies de compression (30) et d'expansion (40) ont des longueurs de lignes hyperfréquences sensiblement identiques.

8. Dispositif selon une des revendications précédentes, **caractérisé en ce qu'**il est essentiellement articulé sur des composants passifs.

## Patentansprüche

1. Vorrichtung zur Linearisierung für eine Mikrowellen-Verstärkerstufe mit einem Eingang (10), gefolgt von einem Separator (20A), der abhängig vom Pegel selektiv ist und unmittelbar einen Kompressionskanal (30) und mittels Reflexion einen Expansionskanal (40) speist, während die Ausgangssignale der beiden Kanäle über einen Kombinationskoppler (80) gekoppelt und an die Verstärkerstufe weitergeleitet werden, **dadurch gekennzeichnet, daß** der Separator einen Zirkulator (21A) enthält, dessen Eingangszugang (21B) an den Eingang (10) der Vorrichtung angeschlossen ist, daß eine einzige abhängig vom Pegel selektive Reflexionsschaltung (22) hinter dem Eingangs-Ausgangs-Zugang (21C) des Zirkulators liegt, auf den einer der Kanäle folgt, und daß der Ausgangszugang (21D) des Zirkulators an den anderen Kanal angeschlossen ist.

2. Vorrichtung nach Anspruch 1, **dadurch gekennzeichnet, daß** die einzige selektive Reflexionsschaltung (22) vom Begrenzertyp ist.

3. Vorrichtung nach einem der vorstehenden Ansprüche, **dadurch gekennzeichnet, daß** die einzige pegelabhängig selektive Reflexionsschaltung (22) eine Schottky-Diode enthält, die in Ableitrichtung liegt.

4. Vorrichtung nach einem der vorstehenden Ansprüche, **dadurch gekennzeichnet, daß** einer der beiden Kanäle eine Phasensteuerschaltung (60) enthält, die abhängig von einem gewählten Phasenkompensationsgesetz justiert ist.

5. Vorrichtung nach einem der vorstehenden Ansprüche, **dadurch gekennzeichnet, daß** der Kompressionskanal (30) eine justierbare Dämpfungsschaltung (50A) enthält.

6. Vorrichtung nach einem der vorstehenden Ansprüche, **dadurch gekennzeichnet, daß** der Expansionskanal (40) eine Verstärkerschaltung mit variablem Verstärkungsgrad enthält.

7. Vorrichtung nach einem der vorstehenden Ansprüche, **dadurch gekennzeichnet, daß** der Kompressionskanal (30) und der Expansionskanal (40) im wesentlichen gleich lange Mikrowellen-Leiterstrecken besitzen.

8. Vorrichtung nach einem der vorstehenden Ansprüche, **dadurch gekennzeichnet, daß** sie im wesentlichen aus passiven Bauelementen besteht.

## Claims

1. Linearizer device for RF amplification stage of the type comprising an input (10), followed by a separator (20A) operating by level-dependent selective reflection, which forward-feeds a compression path (30), and by reflection an expansion path (40), while the outputs of these two paths are united by a combiner coupler (80) so as to go to the amplification stage, **characterized in that** the separator comprises a circulator (21A), whose input port (21B) is linked to the input of the device (10), **in that** a single level-dependent selective reflection arrangement (22) is placed after the input/output port of the circulator (21C), and followed by one of said paths, and **in that** the output port (21D) of the circulator is linked to the other path.

2. Device according to Claim 1, **characterized in that** said single selective reflection arrangement (22) is of the limiter type.

3. Device according to one of the proceding claims, **characterized in that** said single level-dependent selective reflection arrangement (22) is based on a shunt-mounted Schottky diode.

4. Device according to one of the proceding claims, **characterized in that** one of the two paths comprises a phase control circuit (60), adjusted as a function of a chosen phase compensation law.

5. Device according to one of the preceding claims, **characterized in that** the compression path (30) comprises an adjustable attenuator circuit (50A).

6. Device according to one of the proceding claims, **characterized in that** the expansion path (40) comprises a variable-gain amplifier circuit.

7. Device according to one of the preceding claims, **characterized in that** the compression path (30) and expansion path (40) have substantially identical RF line lengths.

8. Device according to one of the preceding claims, **characterized in that** it essentially hinges around passive components.
